Europäisches Patentamt

European Patent Office

Office européen des brevets

(11) Veröffentlichungsnummer: **0 429 859 A2**

## EUROPÄISCHE PATENTANMELDUNG

(21) Anmeldenummer: 90120521.1

(22) Anmeldetag: 26.10.90

(51) Int. Cl.5: **H04L 27/12**

Die Bezeichnung der Erfindung wurde geändert (Richtlinien für die Prüfung im EPA, A-III, 7.3).

(30) Priorität: 28.11.89 DE 3939259

(43) Veröffentlichungstag der Anmeldung: 05.06.91 Patentblatt 91/23

(84) Benannte Vertragsstaaten: DE ES FR GB IT Patentblatt

(71) Anmelder: **Rohde & Schwarz GmbH & Co. KG Mühldorfstrasse 15 W-8000 München 80(DE)**

(72) Erfinder: **Bögl, Thomas, Dipl.-Ing. Nördlinger Strasse 65 W-8901 Königsbrunn(DE)**

(74) Vertreter: **Graf, Walter, Dipl.-Ing. Sckellstrasse 1 W-8000 München 80(DE)**

(54) **Frequenzgenerator, der digital frequenzmodulierbar ist.**

(57) Bei einem frequenzmodulierbaren Frequenzgenerator mit einem phasengeregelten Oszillator wird die Referenzfrequenz durch einen digitalen Frequenzsynthesizer erzeugt, der durch digitale Datensignale frequenzmodulierbar ist; dabei werden gesteuert durch das Datensignal aus einem Register abwechselnd Zahlenwerte ausgelesen, die entsprechend unterschiedliche Frequenzablagen ergeben; in dem Register sind zusätzliche vorbestimmte Zusatzzahlenwerte gespeichert, die Frequenzwerte ergeben, die den Frequenzablagen benachbart sind; das Register ist durch das Datensignal so gesteuert, daß mit jeder Flanke des Datensignals zunächst nacheinander vorbestimmte Zusatzzahlenwerte in einer derartigen Reihenfolge ausgelesen werden, daß durch die damit erzeugten Frequenzwerte ein beim Wechsel zwischen den Ablagefrequenzen auftretendes Überschwingen kompensiert wird.

EP 0 429 859 A2

## FREQUENZMODULIERBARER FREQUENZGENERATOR

Die Erfindung betrifft einen frequenzmodulierbaren Frequenzgenerator laut Oberbegriff des Hauptanspruches.

Phasengeregelte Oszillatoren (PLL-Oszillatoren) können entweder durch entsprechende Beeinflussung der Phasenregelschleife frequenzmoduliert werden oder durch entsprechende Frequenzmodulation der dem Phasendetektor zugeführten Referenzfrequenz. Bei letzterer Art der Frequenzmodulation können durch Überschwing- und Einschwing-Vorgänge während des Frequenzwechsels mehr oder weniger starke Datensignalverzerrungen auftreten. Dies tritt in besonderem Maße bei solchen PLL-Synthesizern auf, bei denen die Parameter für die Phasenregelschleife für optimal schnelles Fangverhalten dimensioniert sein müssen, wie dies beispielsweise für die Ansteuerung von nach dem Frequenzsprungverfahren arbeitenden Nachrichtensendern nötig ist. Durch das störende Überschwingen wird außerdem das Modulationsspektrum unnötig verbreitert und im ZF-Filter eines das Modulationssignal empfangenden Empfängers kann starkes Nachklingeln auftreten, wodurch es auch zu einer schlechteren Detektierbarkeit und damit zu einer Erhöhung der BIT-Fehlrate kommt. Um diesen Nachteil zu vermeiden mußten bei den bekannten Synthesizern dieser Art entweder die Schleifenparameter geändert oder die Datenrate herabgesetzt werden, solche Verzerrungen konnten bisher also nur durch Inkaufnahme einer Verschlechterung der Leistungsfähigkeit des Synthesizers vermieden werden.

Es sind auch reine digitale Synthesizer bekannt, bei denen das Ausgangssignal durch direkte digitale Synthese erzeugt wird (Neues von Rohde & Schwarz Nr. 123, Herbst 1988, S. 16, US-PS 3 735 269, DE-PS 37 40 130). Solche digitalen Synthesizer können auch auf einfache Weise durch ein digitales Datensignal (Rechteckimpulse) in der Frequenz moduliert werden, dazu ist es nur nötig, dem Steuereingang des Synthesizers ein entsprechendes Register zuzuordnen, in welchem die beiden gegenüber einer Mittenfrequenz benachbarten Ablagefrequenzen, die den Frequenzhub bestimmen, als Zahlenwerte gespeichert sind, die zur Modulation in Abhängigkeit vom Datensignal abwechselnd ausgelesen werden. Solchen reinen digitalen Synthesizer besitzen jedoch den Nachteil geringer Nebenwellenfreiheit.

Es ist Aufgabe der Erfindung, einen mit Digitalsignalen frequenzmodulierbaren Frequenzgenerator zu schaffen, bei dem unabhängig von der Dimensionierung der Regelparameter und der Datenrate Datenverzerrungen durch Überschwingen vermieden sind.

Diese Aufgabe wird ausgehend von einem Frequenzgenerator laut Oberbegriff des Hauptanspruches durch dessen kennzeichnende Merkmale gelöst. Eine vorteilhafte Weiterbildung ergibt sich aus dem Unteranspruch.

Bei dem erfindungsgemäßen frequenzmodulierbaren Frequenzgenerator wird im digitalen Synthesizer in Abhängigkeit von den Flanken des Datensignals nicht hart zwischen den die beiden Ablagefrequenzen ergebenden Zahlenwerten umgeschaltet, sondern vielmehr nach einer vorgegebenen Frequenzfunktion schrittweise mit mehreren unterschiedlichen Frequenzwerten. Diese Frequenzwerte und deren Reihenfolge richten sich nach den zu erwartenden Überschwingvorgängen, diese Werte können entweder errechnet oder empirisch ermittelt werden. Die Wahl dieser Übergangs-Frequenzwerte zu Beginn jeder Datenflanke ist völlig frei, es kann für beliebige Phasenregelschleifen, die je nach Dimensionierung unterschiedliches Überschwingverhalten besitzen, jeweils der genau dazu passende kompensierende Frequenzübergang ermittelt werden. Durch entsprechende Wahl dieser Übergangsfrequenzen kann so einerseits ein gewünschter schneller Modulationsanstieg erreicht werden, gleichzeitig jedoch ein aperiodisches Einschwingen erzielt werden. Die Erfindung ist für alle Arten von PLL-Frequenzsynthesizern geeignet, bei denen bei der Modulation die erwähnten Überschwingvorgänge auftreten.

Die Erfindung wird im folgenden anhand schematischer Zeichnungen an einem Ausführungsbeispiel eines solchen Synthesizers näher erläutert.

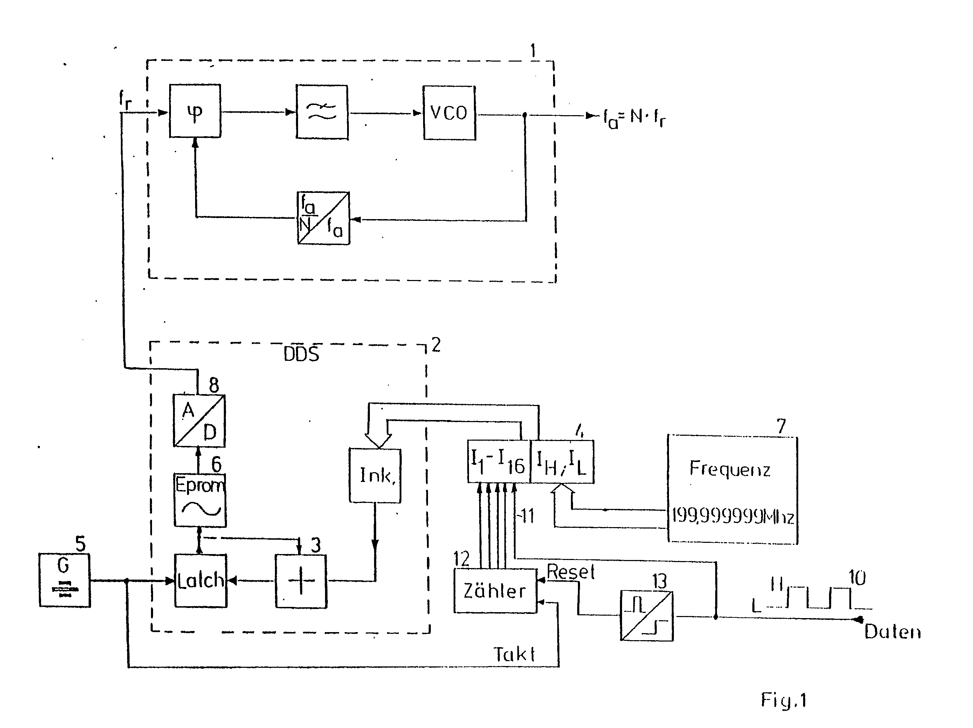

Fig. 1 zeigt das Prinzipschaltbild eines Normalfrequenzgenerators mit einem phasengeregelten Oszillator 1 bekannter Bauart, dessen Referenzfrequenz $f_r$ durch einen bekannten digitalen Synthesizer 2 erzeugt wird. Dieser digitale Synthesizer umfaßt einen Addierer 3, in welchem fortlaufend Zahleninkremente aufaddiert werden, die aus einem Inkrementregister 4 dem Addierer zugeführt werden. Dem Addierer 3 wird aus einem Taktgenerator 5 eine feste Taktfrequenz zugeführt. Der Ausgang des Addierers 3 ist mit einem Speicher 6 verbunden, in welchem die Stützwerte einer vollen Sinusperiode abgespeichert sind. Während eines Addierzyklus des Addierers wird Schritt für Schritt eine volle Sinusperiode aus diesem Speicher 6 ausgelesen. Die ausgelesenen Digitalwerte werden in einem Digital/Analog-Wandler 8 zu einem analogen Sinussignal gewandelt, das dann als Referenzfrequenz dem Phasenvergleichsglied des phasengeregelten Oszillators 1 zugeführt wird. Die Frequenz dieser Sinusperiode wird durch die Größe des aufaddierten Inkrements bestimmt, zur Frequenzeinstellung ist dem Inkrementregister 4 eine Einstellvorrichtung 7 zugeordnet, an welcher die gewünschte Ausgangsfrequenz einstellbar ist.

Zur Frequenzmodulation dieses digitalen Synthesizers 2 mit einem zwischen 0 und 1 umschaltbaren Rechteck-Datensignals 10 ist ein zusätzlicher Steuereingang 11 am Inkrementregister 4 vorgesehen, der es erlaubt, in Abhängigkeit von dem Datensignal 10 abwechselnd zwei relativ benachbarte Zahleninkremente auszulesen, die damit zwei unterschiedliche Ablagefrequenzen ergeben. Liegt am Eingang 11 H-Potential des Datensignals 10 an, so wird ein Inkrement $I_H$ aus dem Inkrementregister 4 ausgelesen und damit am Ausgang des Synthesizers 2 die Frequenz $f_H$ erzeugt. Liegt am Eingang 11 L-Potential des Datensignales 10 an, wird ein Inkrement $I_L$ ausgelesen und damit die Ausgangsfrequenz $f_L$ erzeugt.

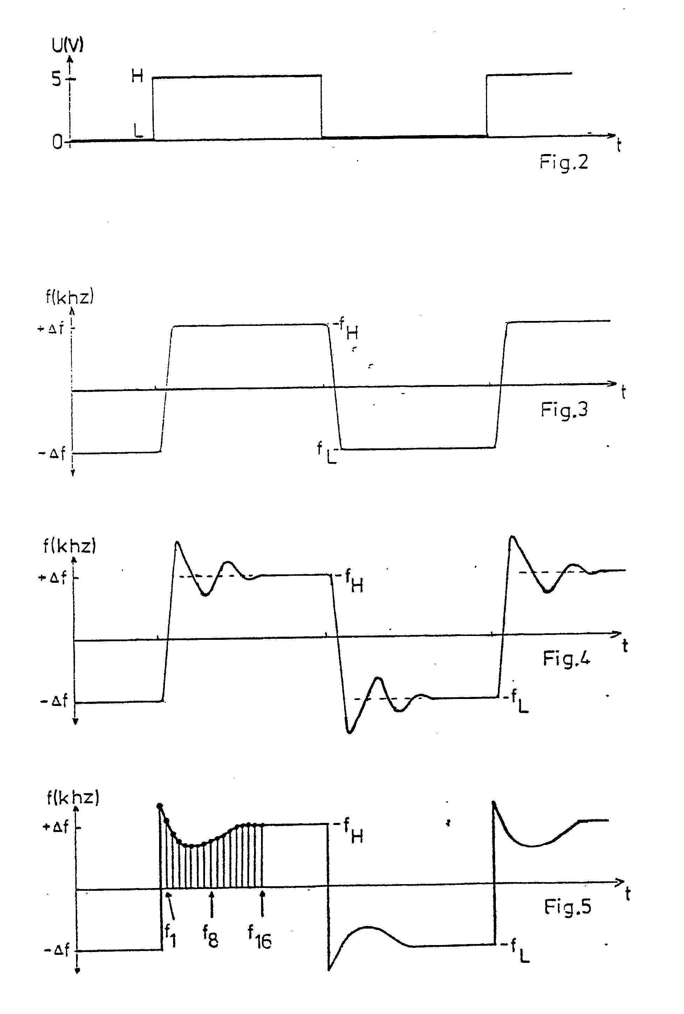

Figuren 2 und 3 zeigen schematisch diesen Zusammenhang.

Je nach Dimensionierung der Phasenregelschleife 1 wird jedoch nicht der in Fig. 3 ideale Frequenzverlauf erzielt, sondern ein mehr oder weniger durch Überschwingen verzerrter Frequenzverlauf der Ausgangsfrequenz $f_a$, wie dies Fig. 4 zeigt. Sowohl bei ansteigender als auch bei abfallender Datenflanke tritt zunächst ein mehr oder weniger starkes Überschwingen ein, bis nach einem Einschwingvorgang der gewünschte Ablagefrequenzwert $f_H$ bzw. $f_L$ erreicht ist.

Um dieses Überschwingen zu kompensieren sind im Inkrementregister 4 nicht nur die Inkremente $I_H$ und $I_L$ abgespeichert, sondern eine Reihe von Zusatzinkrementen, die bei jedem Ablagefrequenzwechsel in einer vorbestimmten Reihenfolge als Zwischenwerte ausgelesen werden. Dazu ist ein zusätzlicher Zähler 12 vorgesehen, der in Abhängigkeit vom Datensignal 10 über einen Flankendetektor 13 ansteuerbar ist und über welchen ausgewählte Adressen des Inkrementregisters auslesbar sind. In dem gezeigten Ausführungsbeispiel ist ein 4-Bit-Zähler 12 vorgesehen, über welchen damit sechzehn Adressen im Inkrementregister 4 ausgelesen werden können. An diesen sechzehn Adressen des Inkrementregisters 4 sind vorbestimmte Zahleninkremente abgespeichert, die gemäß Fig. 5 jeweils ausgewählte Frequenzwerte f1 bis f16 ergeben. Bei jeder Anstiegs- bzw. Abfallflanke des Datensignales 10 wird der Zähler 16 gesteuert durch den Flankendetektor 13 zurückgesetzt und beginnt dann mit der Taktfrequenz nach oben zu zählen. Wenn der Zähler seinen Maximalwert erreicht, bleibt er stehen, beim 4-Bit-Zähler nach dem Ausführungsbeispiel also beim Zählwert 15. Während es Zählvorgangs werden nacheinander aus dem Inkrementregister 4 die an den zugehörigen Adressen abgespeicherten Inkrementwerte ausgelesen, die den erwähnten Frequenzwerten f1 bis f16 entsprechen. In dem Ausführungsbeispiel nach Fig. 5 wird also beginnend mit der Anstiegsflanke aus der ersten Adresse des Inkrementregisters 4 der Frequenzwert f1 ausgelesen, der in dem gezeigten Ausführungsbeispiel größer ist als der eigentliche Ablagefrequenzwert $f_H$. Dadurch wird beispielsweise eine gewünschte schnelle Modulationsanstiegszeit erreicht. Anschließend werden dann nacheinander immer niedriger werdende Frequenzwerte f2 bis f8 ausgelesen, dann beispielsweise wieder ansteigend Frequenzwerte f8 bis f15, bis schließlich der Zähler nach Erreichen seines Maximalwertes stehenbleibt und dann der letzte Frequenzwert f16 statisch stehenbleibt, der natürlich dem gewünschten Ablagefrequenzwert $f_H$ (bzw. $f_L$) an der Abstiegsflanke entspricht. Bei der nächsten Flanke wiederholt sich dieser Vorgang. Die Größe und Reihenfolge der einzelnen Frequenzwerte f1 bis f16 richtet sich nach der Art und Größe des Frequenzüberschwingens in der Synthesizer-Regelschleife, wie dies in Fig. 2 c) schematisch angedeutet ist. Fig. 5 zeigt, daß der Verlauf der Übergangsfrequenzen f1 bis f16 nach jeder Flanke in etwa dem Frequenzverlauf eines Überschwinghöckers nach Fig. 4 entspricht, obwohl dieser Zusammenhang nicht zwingend ist. Der Frequenzverlauf nach Fig. 5 wird zweckmäßigerweise durch Versuch ermittelt, bis schließlich ein völlig überschwingfreies Ausgangssignal, das mehr oder weniger ideal dem Verlauf nach Fig. 5 entspricht, erreicht ist.

Das erfindungsgemäße Prinzip, Verzerrungen, die in einer Regelschleife eines Systems auftreten, das über einen digitalen Synthesizer angesteuert ist, dadurch zu vermeiden, daß das den Verzerrungen unterworfene Datensignal vorher entsprechend vorverzerrt wird, ist nicht nur für die entsprechende Voreinstellung von Frequenzwerten geeignet, sondern in analoger Weise auch für Systeme, bei denen durch die Amplitude eines digital erzeugten Signals entsprechende Verzerrungen in einem Amplitudenregelkreis auftreten. In diesem Fall wird analog zu Fig. 5 das dem Amplituden-Regelsystem zugeführte Datensignal in der Amplitude entsprechend voreingestellt, wodurch dann die im System bewirkten Amplitudenverzerrungen ausgeglichen werden.

**Ansprüche**

1. Frequenzmodulierbarer Frequenzgenerator mit einem phasengeregelten Oszillator (1), dessen Referenzfrequenz durch ein digitales Datensignal (10) zwischen unterschiedlichen Frequenzablagen ($f_H$, $f_L$) umschaltbar ist, dadurch **gekennzeichnet,** daß die Referenzfrequenz ($f_r$) in einem digitalen Frequenzsynthesizer (2) erzeugt ist, in welchem gesteuert durch das Datensignal (10) aus einem Register (4) abwechselnd Zahlenwerte ($I_H$, $I_L$) auslesbar sind, die den unterschiedlichen Frequenzablagen ($f_H$, $f_L$)entsprechen, wobei in dem Register (4) zusätzliche vor-bestimmte Zusatzzahlenwerte (I - I16) gespeichert sind, die Frequenzwerte (f1 bis f16) ergeben, die den Frequenzablagen ($f_H$,$f_L$) benachbart sind, wobei das Register (4) durch das Datensignal (10) so gesteuert ist, daß mit jeder Flanke des Datensignals zunächst nacheinander vorbestimmte Zusatzzahlenwerte (11 bis I16) in einer derartigen Reihenfolge ausgelesen werden, daß durch die damit erzeugten Frequenzwerte (f1 bis f16) ein beim Wechsel zwischen den Ablagefrequenzen ($f_H$,$f_L$) auftretendes Überschwingen kompensiert wird.

2. Frequenzgenerator nach Anspruch 1, dadurch **gekennzeichnet**, daß die Zusatzzahlenwerte (11 bis I16) mittels eines Zählers (12) aus dem Register (4) auslesbar sind und dieser Zähler (12) durch einen Flankendetektor (13) in Abhängigkeit vom Datensignal (10) so gesteuert ist, daß mit jeder Flanke des Datensignals der Zähler (12) zurückgesetzt und dann bis zu einem vorgegebenen Maximalwert zählt, wodurch nacheinander die vorgegebenen Zusatzzahlenwerte (I1 bis I16) aus dem Register (4) ausgelesen werden und bei Erreichen des Maximalwerts ein der vorgegebenen Frequenzablage ($f_H$ bzw. $f_L$) entsprechender konstanter Zahlenwert ($I_H$,$I_L$) ausgegeben wird.

Fig.1

EP 0 429 859 A2

U(V)

5

H

L

0

Fig.2

t

f(khz)

+Δf

-f_H

-Δf

f_L

Fig.3

t

f(khz)

+Δf

f_H

-Δf

f_L

Fig.4

t

f(khz)

+Δf

f_H

-Δf

$f_1$   $f_8$   $f_{16}$

f_L

Fig.5

t